# EUROPEAN PATENT APPLICATION

(11) **EP 3 637 443 A1**
(43) Date of publication of application: **15.04.2020**
(21) Application number: 18199682.8
(22) Date of filing: 10.10.2018
(51) Int. Cl.: H01F 13/00, H01F 17/00, H05K 1/16, H01F 27/32, H01F 41/04, D03D 1/00

(54) **INDUCTIVE COMPONENTS AND METHODS OF FORMING INDUCTIVE COMPONENTS**

(71) Applicant: Nokia Technologies Oy, 02610 Espoo (FI)
(72) Inventor: DERRICK, Philip, Cambridge, Cambridgeshire CB3 0FA (GB); SASSI, Ugo, Cambridge, Cambridgeshire CB3 0FA (GB); RADIVOJEVIC, Zoran, Cambridge, Cambridgeshire CB3 0FA (GB)
(74) Representative: Swindell & Pearson Limited

(57) **Abstract**

The application relates to inductive components (113) and methods of forming inductive components that could be used in wearable electronic devices. The inductive components comprise: a plurality of first conductive portions (101); a first insulating layer (103), wherein the first insulating layer overlays at least part of the a plurality of first conductive portions; a magnetic core (105) at least partially overlaying the first insulating layer; a second insulating layer (107), wherein the second insulating layer overlays the magnetic core; and a plurality of second conductive portions (109) overlaying at least part of the second insulating layer so that the plurality of second conductive portions contacts the plurality of first conductive portions to form a conductive coil (111) around the magnetic core and first insulating layer and second insulating layer. The plurality of first conductive portions, the first insulating layer, the magnetic core, the second insulating layer and the plurality of second conductive portions are formed using one or more two dimensional printing processes.

## Description

### TECHNOLOGICAL FIELD

Examples of the present disclosure relate to inductive components and methods of forming inductive components. Some examples relate to inductive components and methods of forming inductive components for use in wearable electronic devices.

### FUNDING

The project leading to this application has received funding from the European Union's Horizon 2020 research and innovation program under grant agreement No 785219 - GrapheneCore2.

### BACKGROUND

Wearable electronic devices comprise electronic components which can be integrated within the fabric of an article of clothing or strap or other suitable means. The electronic components need to be comfortable, water and sweat proof and washable.

### BRIEF SUMMARY

According to various, but not necessarily all, examples of the disclosure there is provided an inductive component comprising: a plurality of first conductive portions; a first insulating layer, wherein the first insulating layer overlays at least part of the a plurality of first conductive portions; a magnetic core at least partially overlaying the first insulating layer; a second insulating layer, wherein the second insulating layer overlays the magnetic core; and a plurality of second conductive portions overlaying at least part of the second insulating layer so that the plurality of second conductive portions contacts the plurality of first conductive portions to form a conductive coil around the magnetic core and first insulating layer and second insulating layer; wherein the plurality of first conductive portions, the first insulating layer, the magnetic core, the second insulating layer and the plurality of second conductive portions are formed using one or more two dimensional printing processes.

Respective parts of the inductive component may be formed using different two dimensional printing processes and the respective parts comprise one or more of the plurality of first conductive portions, the first insulating layer, the magnetic core and the plurality of second conductive portions.

The two dimensional printing processes may comprise one or more of; ink jet printing, screen printing, spray coating.

The inductive component may be formed on fabric.

The inductive component may be formed on a flexible substrate and transferred to fabric after the inductive component has been formed.

The inductive component may comprise: a first conductive coil around the magnetic core and first insulating layer and second insulating layer; and a second conductive coil around the magnetic core and first insulating layer and second insulating layer; wherein the first coil and the second coil are configured to form a transformer. An intervening insulating layer may be provided between portions of the first conductive coil and portions of the second conductive coil. The transformer may comprise at least one of; shell type transformer, core type transformer.

According to various, but not necessarily all, examples of the disclosure there is provided a wearable electronic device comprising an inductive component as described in the preceding paragraphs.

According to various, but not necessarily all, examples of the disclosure there is provided a method of forming an inductive component comprising: forming a plurality of first conductive portions; forming a first insulating layer, wherein the first insulating layer overlays at least part of the plurality of first conductive portions; forming a magnetic core at least partially overlaying the first insulating layer; forming a second insulating layer, wherein the second insulating layer overlays the magnetic core; and forming a plurality of second conductive portions overlaying at least part of the second insulating layer so that the plurality of second conductive portions contacts the plurality of first conductive portions to form a conductive coil around the magnetic core and first insulating layer and second insulating layer; wherein the plurality of first conductive portions, the first insulating layer, the magnetic core, the second insulating layer and the plurality of second conductive portions are formed using one or more two dimensional printing processes.

Respective parts of the inductive component may be formed using different two dimensional printing processes and the respective parts comprise one or more of the plurality of first conductive portions, the first insulating layer, the magnetic core and the plurality of second conductive portions.

The two dimensional printing processes may comprise one or more of; ink jet printing, screen printing, spray coating.

The inductive component may be formed on fabric.

The inductive component may be formed on a flexible substrate and transferred to fabric after the inductive component has been formed.

The method may also comprise forming a first conductive coil around the magnetic core and first insulating layer and second insulating layer: and forming a second conductive coil around the magnetic core and first insulating layer and second insulating layer; and wherein the first coil and the second coil are configured to form a transformer. An intervening insulating layer may be formed between portions of the first conductive coil and portions of the second conductive coil. The transformer may comprise at least one of; shell type transformer, core type transformer.

According to various, but not necessarily all, examples of the disclosure there is provided a method comprising forming a wearable electronic device using the inductive component within the wearable electronic device.

### BRIEF DESCRIPTION

Some example embodiments will now be described with reference to the accompanying drawings in which:
Figs. 1A to 1E show a method of forming an inductive component;
Figs. 2A to 2I show a method of forming another inductive component;
Figs. 3A and 3B show another type of inductive component; and
Fig. 4 shows a wearable electronic device comprising at least one inductive component.

### DETAILED DESCRIPTION

Examples of the disclosure relate to a method of forming inductive component 113 and different types of inductive components 113 that may be formed by variations of the method. The method comprises forming the respective parts of the inductive component 113 using one or more two dimensional printing processes. The respective parts of the inductive component 113 may comprise at least; a plurality of first conductive portions 101, a first insulating layer 103, wherein the first insulating layer 103 at least partially overlays at least part of the plurality of first conductive portions 103, a magnetic core 105 overlaying the first insulating layer 103, a second insulating layer 107, wherein the second insulating layer 107 overlays the magnetic core 105, and a plurality of second conductive portions 109 overlaying at least part of the second insulating layer 103 so that the plurality of second conductive portions 109 contacts the plurality of first conductive portions 101 to form a conductive coil 111 around the magnetic core 105 and first insulating layer 103 and second insulating layer 107.

The inductive component 113 could be an inductor 115, a transformer 207, 301 or any other suitable type of inductive component.

The use of one or more two dimensional printing processes to form an inductive component 113 and/or the respective parts of the inductive component enables the inductive component to be formed from flexible materials. The inductive component 113 may be small and lightweight and suitable for use within a wearable electronic device 401. The inductive component 113 may be small enough and light enough so that a wearable electronic device 401 comprising the inductive component would still be comfortable for a subject to wear. For instance, there would be no bulky components or components that project too far out of the surface of the wearable electronic device 401 which may be uncomfortable for the subject. The use of two dimensional printing processes also enables the inductive component 113 to be provided at any suitable position within the wearable electronic device 401.

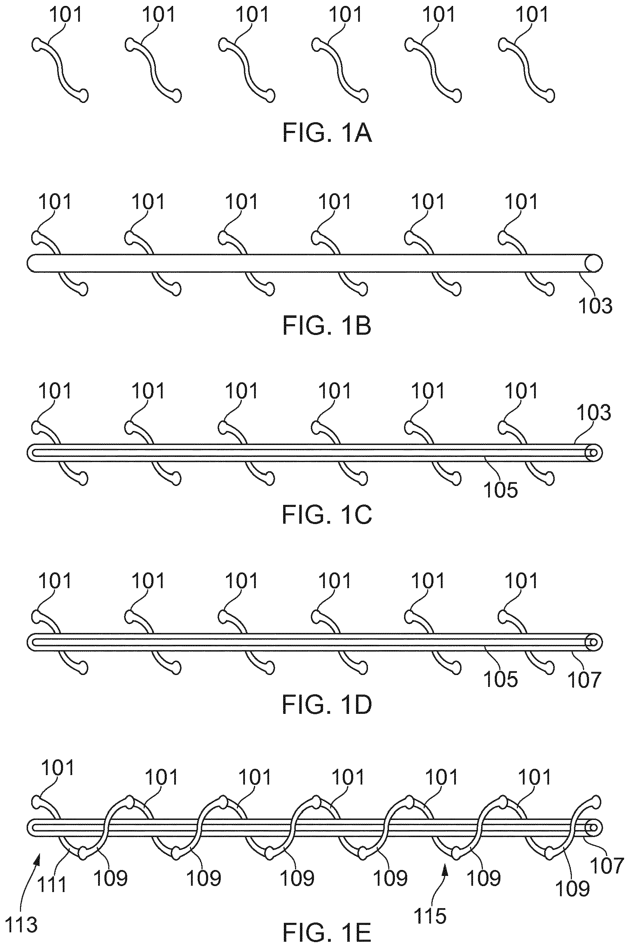

Figs. 1A to 1E show an example method which may be used to form an inductive component 113. In the example of Figs. 1A to 1E the inductive component is an inductor 115. Other types of inductive components 113 may be formed using variations of the method shown in Figs. 1A to 1E.

In Fig. 1A a plurality of first conductive portions 101 are formed. The plurality of first conductive portions 101 are formed using a two dimensional printing process such as ink jet printing, screen printing, spray coating or any other suitable process. The printing process is two dimensional in that it produces a flat, or substantially flat, element on a flat, or substantially flat, surface. This is distinct from three dimensional printing processes, or other additive manufacturing processes, which build up multiple layers so as to create a three dimensional object. In examples of the disclosure the two dimensional printing processes may be used to create different parts of the inductive component 113. The different parts may be combined to form a three dimensional inductive component 113. Different two dimensional printing processes, and or different materials, may be used to form the different parts of the inductive component 113.

The first conductive portions 101 may be formed from any conductive material which can be used in a two dimensional printing process. The conductive material may be provided in the form of a paste or ink for use in the two dimensional printing process. In some examples the conductive material could comprise carbon such as carbon black, carbon composites, graphene, carbon nanotubes, or any other suitable conductive carbon based material. In some examples the conductive material could comprise, copper silver, nickel, ferrite or any other suitable material.

In the example shown in Fig. 1A six first conductive portions 101 are shown. It is to be appreciated that any number of first conductive portions 101 could be printed in implementations of the disclosure.

The plurality of first conductive portions 101 are printed in a line so that they are spaced from each other. There is a gap between each of the plurality of first conductive portions 101 so that, at the stage of the method shown in Fig. 1A, there is no direct current path between the first conductive portions 101.

In the example shown in Fig. 1A each of the first conductive portions 101 has the same, or substantially the same shape. In the example shown in Fig. 1A the first conductive portions 101 are formed in a reverse S shape. The reverse S extends diagonally from a top left point to a bottom right point. It is to be appreciated that other shapes and configurations of the first conductive portions 101 could be used in other examples of the disclosure.

In Fig. 1B a first insulating layer 103 is formed The first insulating layer 103 is formed using a two dimensional printing process such as ink jet printing, screen printing, spray coating or any other suitable process.

The first insulating layer 103 may be formed from any suitable insulating material which can be used in a two dimensional printing process. The insulating material may be provided in the form of a paste or ink for use in the two dimensional printing process. In some examples the insulating material could comprise polymers such as polyethylene (PE), polyethylene terephthalate (PET), polyvinylchloride (PVC), polyurethane (PU), polyimide (PI), polypropylene (PP), polystyrene (PS), polymethylmethacrylate (PMMA) or any other suitable insulating material.

The first insulating layer 103 is formed so that it, at least partially, overlays at least part of the plurality of first conductive portions 101. The first insulating layer 103 may be printed over the plurality of first conductive portions 101 so that the first insulating layer 103 is in direct contact with the plurality of first conductive portions 101. There might be no intervening components between the first insulating layer 103 and the first conductive portions 101.

In the example shown in Fig. 1B the first insulating layer 103 is provided as an elongated strip that extends in a horizontal direction. The elongated strip covers at least part of the plurality of first conductive portions 101 and also parts of the gaps between adjacent first conductive portions 101. The first insulating layer 103 has a width such that at least some parts of the first conductive portions 101 are not covered by the first insulating layer 103. This leaves some parts of the first conductive portions 101 exposed and able to contact other conductive portions.

In the example of Fig. 1B the first insulating layer 103 covers at least part of each of the plurality of first conductive portions 101. In other examples the first insulating layer 103 might cover parts of only a subset of the first conductive portions 101 so that some of the first conductive portions 101 are not covered by the first insulating layer 103.

In Fig. 1C a magnetic core 105 is formed. The magnetic core 105 is formed using a two dimensional printing process such as ink jet printing, screen printing, spray coating or any other suitable process.

The magnetic core 105 may be formed from any suitable magnetic material which can be used in a two dimensional printing process. The magnetic material may be provided in the form of a paste or ink for use in the two dimensional printing process. In some examples the magnetic material could comprise magnetic rare earth metals such as neodymium alloys or any other suitable magnetic material.

The magnetic core 105 is formed so that it overlays the first insulating layer 103. The magnetic core 105 may be printed over the first insulating layer 103 so that the first magnetic core 105 is in direct contact with the first insulating layer 103. There might be no intervening components between magnetic core 105 and the first insulating layer 103 and the first conductive portions 101.

In the example shown in Fig. 1C the magnetic core 105 is provided as an elongated strip that extends in a horizontal direction. The magnetic core 105 extends over the plurality of first conductive portions 101 and also parts of the gaps between adjacent first conductive portions 101. In the example of Fig. 1C the magnetic core 105 completely overlays the first insulating layer 103 so that no portion of the magnetic core 105 extends over the first insulating layer 103. The first insulating layer 103 prevents any direct current path between the plurality of first conductive portions 101 and the magnetic core 105.

In Fig. 1D a second insulating layer 107 is formed. The second insulating layer 107 is formed using a two dimensional printing process such as ink jet printing, screen printing, spray coating or any other suitable process.

The second insulating layer 107 may be formed from any suitable insulating material which can be used in a two dimensional printing process. The second insulating layer 107 may be formed from the same type of material as the first insulating layer 103.

The second insulating layer 107 is formed so that it overlays the magnetic core 105. In the example shown in Fig. 1D the second insulating layer 107 has the same size and shape, or substantially the same size and shape, as the first insulating layer 103. The second insulating layer 107 is formed over both the first insulating layer 103 and the magnetic core 105 so that the first insulating layer 103 and the second insulating layer 107 form an insulating portion which surrounds the magnetic core 105.

In Fig. 1E a plurality of second conductive portions 109 are formed. The plurality of second conductive portions 109 are formed using a two dimensional printing process such as ink jet printing, screen printing, spray coating or any other suitable process.

The second conductive portions 109 may be formed from any conductive material which can be used in a two dimensional printing process. The second conductive portions 109 could be formed from the same type of material used for the first conductive portions 101.

In the example shown in Fig. 1E six second conductive portions 109 are shown. It is to be appreciated that any number of second conductive portions 109 could be printed in implementations of the disclosure. The number of second conductive portions 109 could be the same as the number of first conductive portions 101.

The plurality of second conductive portions 109 are formed overlaying at least part of the second insulating layer 107. The plurality of second conductive portions 109 may be printed over the second insulating layer 107 so that the second insulating layer 107 is in direct contact with the plurality of second conductive portions 109. There might be no intervening components between the second insulating layer 107 and the plurality of second conductive portions 109. The second insulating layer 107 may prevent any direct current paths between the magnetic core 105 and the plurality of second conductive portions 109.

The second conductive portions 109 extend across the gaps between the adjacent first conductive portions 101 to provide a direct current path between adjacent first conductive portions 101. This enables the first conductive portions 101 and the second conductive portions 109 to form a conductive coil 111 around the magnetic core 105 and first insulating layer 103 and second insulating layer 107. In the example shown in Fig. 1E each of the second conductive portions 109 is printed so that a first end of the second conductive portion 109 contacts a first end of a first conductive portion 101 and a second end of the second conductive portion 109 contacts a second end of an adjacent first conductive portion 101.

In the example shown in Fig. 1E each of the second conductive portions 109 has the same, or substantially the same shape. In the example shown in Fig. 1E the second conductive portions 109 are formed in an S shape. The S shape used for the second conductive portions 109 is a mirror image of the reverse S shape used for the first conductive portions 101. The S extends diagonally from a bottom left point to a top right point. It is to be appreciated that other shapes and configurations of the second conductive portions 109 could be used in other examples of the disclosure.

The method shown in Figs. 1A to 1E enables an inductive component 113 to be formed. In the example of Fig. 1E the inductive component 113 is an inductor 115 which comprises a magnetic core 105 with a conductive coil 111 around the magnetic core 105. Other types of inductive component 113 may be formed using variations of the method.

The example inductor 115 shown in Fig. 1E can be used wherever an inductance is required within an electronic device. For instance could be used within an antenna arrangement, resonance circuitry, filtering circuitry or with any other suitable components.

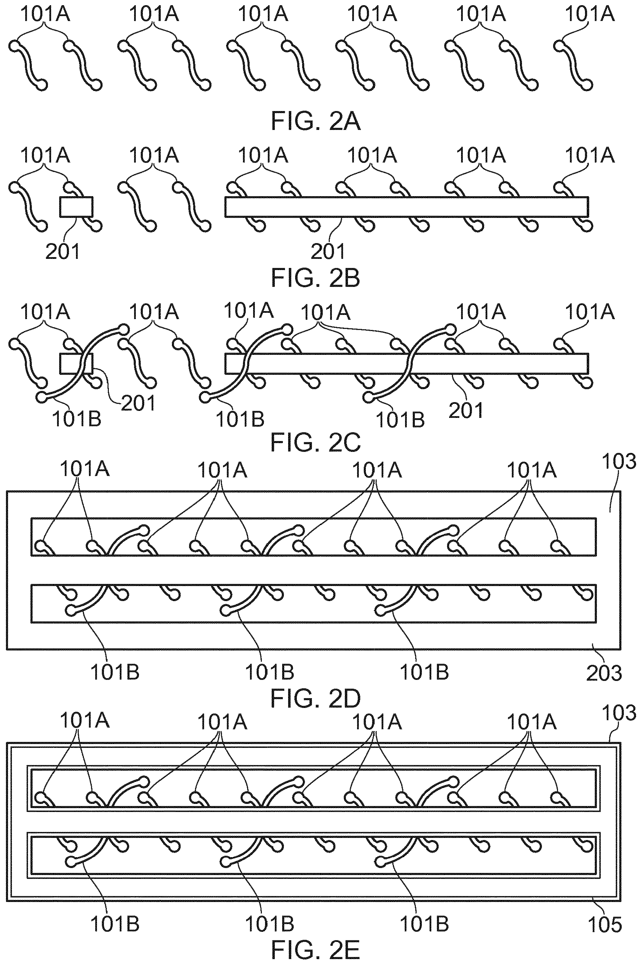

Figs. 2A to 2I show a method of forming another inductive component 113. In the example shown in Figs. 2A to 2I the inductive component 113 is a transformer 207 which comprises two coils 111A, 111B around a magnetic core 105.

In Fig. 2A a plurality of first conductive portions 101A of a first coil 111A are formed. The plurality of first conductive portions 101A of the first coil 111A are formed using a two dimensional printing process such as ink jet printing, screen printing, spray coating or any other suitable process.

The first conductive portions 101A of the first coil 111A may be formed from any conductive material which can be used in a two dimensional printing process. The conductive material may be provided in the form of a paste or ink for use in the two dimensional printing process. In some examples the conductive material could comprise carbon such as carbon black, carbon composites, graphene, carbon nanotubes, or any other suitable conductive carbon based material. In some examples the conductive material could comprise, copper silver, nickel, ferrite or any other suitable material.

In the example shown in Fig. 2A eleven first conductive portions 101A of the first coil 111A are shown. It is to be appreciated that any number of first conductive portions 101A of the first coil 111A could be printed in implementations of the disclosure.

The first conductive portions 101A of the first coil 111A are printed in a line so that they are spaced from each other. There is a gap between each of the plurality of first conductive portions 101A of the first coil 111A so that, at the stage of the method shown in Fig. 2A, there is no direct current path between the first conductive portions 101A of the first coil 111A.

In the example shown in Fig. 2A each of the first conductive portions 101A of a first coil the first coil 111A has the same, or substantially the same shape. In the example shown in Fig. 2A the first conductive portions 101A of the first coil 111A are formed in a reverse S shape. The reverse S extends diagonally from a top left point to a bottom right point. It is to be appreciated that other shapes and configurations of the first conductive portions 101A of the first coil 111A could be used in other examples of the disclosure.

In Fig. 2B an intervening insulating layer 201 is formed. The intervening insulating layer 201 is formed using a two dimensional printing process such as ink jet printing, screen printing, spray coating or any other suitable process.

The intervening insulating layer 201 may be formed from any suitable insulating material which can be used in a two dimensional printing process. The insulating material may be provided in the form of a paste or ink for use in the two dimensional printing process. In some examples the insulating material could comprise polymers such as polyethylene (PE), polyethylene terephthalate (PET), polyvinylchloride (PVC), polyurethane (PU), polyimide (PI), polypropylene (PP), polystyrene (PS), polymethylmethacrylate (PMMA) or any other suitable insulating material.

The intervening insulating layer 201 is formed so that it overlays at least part of the plurality of first conductive portions 101A the first coil 111A. The intervening insulating layer 201 may be printed over the plurality of first conductive portions 101A of the first coil 111A so that the intervening insulating layer 201 is in direct contact with the plurality of first conductive portions 101A of the first coil 111A. There might be no intervening components between the intervening insulating layer 201 and the first conductive portions 101A of the first coil 111A.

In the example shown in Fig. 2B the intervening insulating layer 201 is provided as a plurality of elongated strips that extend in a horizontal direction. The elongated strips cover at least part of the plurality of first conductive portions 101A of the first coil 111A and also parts of the gaps between adjacent first conductive portions 101A of the first coil 111A. In the example shown in Fig. 2B two elongated strips are shown. The first elongated strip overlays a first subset of the first conductive portions 101A of the first coil 111A and a second elongated strip overlays a second subset of the first conductive portions 101A of the first coil 111A. A gap is provided between adjacent elongated strips. Having the gaps may reduce the amount of insulating material that is used.

The intervening insulating layer 201 has a width such that at least some parts of the first conductive portions 101A of the first coil 111A are not covered by the intervening insulating layer 201. This leaves some parts of the first conductive portions 101A of the first coil 111A exposed and able to contact other conductive portions.

In Fig. 2C a plurality of first conductive portions 101B of a second coil 111B are formed. The plurality of first conductive portions 101B of the second coil 111B are formed using a two dimensional printing process such as ink jet printing, screen printing, spray coating or any other suitable process. The first conductive portions 101B of the second coil 111B could be formed using the same type of material as the first conductive portions 101A of the first coil 111A.

The plurality of first conductive portions 101B of the second coil 111B are formed overlaying at least part of the intervening insulating layer 201. The plurality y of first conductive portions 101B of the second coil 111B may be printed over the intervening insulating layer 201 so that the intervening insulating layer 201 is in direct contact with the plurality of first conductive portions 101B of the second coil 111B. There might be no intervening components between the intervening insulating layer 201 and the plurality of first conductive portions 101B of the second coil 111B. The intervening insulating layer 201 may prevent any direct current paths between the plurality of first conductive portions 101A of the first coil 111A and the plurality of first conductive portions 101B of the second coil 111B.

In the example shown in Fig. 2C three first conductive portions 101B of the second coil 111B are shown. It is to be appreciated that any number of first conductive portions 101B of the second coil 111B could be printed in implementations of the disclosure.

The first conductive portions 101B of the second coil 111B are printed in a line so that they are spaced from each other. There is a gap between each of the plurality of first conductive portions 101B of the second coil 111B so that, at the stage of the method shown in Fig. 2C, there is no direct current path between the first conductive portions 101B of the second coil 111B.

In the example shown in Fig. 2C each of the first conductive portions 101B of the second coil 111B has the same, or substantially the same shape. In the example shown in Fig. 2C the conductive first portions 101B of the second coil 111B are formed in an S shape. The S extends diagonally from a bottom left point to a top right point. It is to be appreciated that other shapes and configurations of the first conductive portions 101B of the second coil 111B could be used in other examples of the disclosure.

In the example shown in Fig. 2C the first conductive portions 101B of the second coil 111B have a different size to the first conductive portions 101A of the first coil 111A. This may enable the second coil 111B to have fewer turns than the first coil 111A so as to enable the transformer 207 to provide a change in voltage.

In Fig. 2D a first insulating layer 103 is formed. The first insulating layer 103 is formed using a two dimensional printing process such as ink jet printing, screen printing, spray coating or any other suitable process. The first insulating layer 103 may be formed using the same type of material as the intervening insulating layer 201.

The first insulating layer 103 is formed so that it overlays at least part of the plurality of first conductive portions 101A, 101B of both the first coil 111A and the second coil 111B. The first insulating layer 103 may be printed over the plurality of first conductive portions 101A, 101B so that the first insulating layer 103 is in direct contact with the plurality of first conductive portions 101B of the second coil 111B but there are intervening components between the first insulating layer 103 and the first conductive portions 101A of the first coil 111A.

In the example shown in Fig. 2D the first insulating layer 103 is provided so that it covers at least part of the plurality of first conductive portions 101A, B of both the first coil 111A and the second coil 111B and also parts of the gaps between adjacent first conductive portions 101A, B while leaving at least some parts of the first conductive portions 101A, 101B not covered by the first insulating layer 103. This leaves some parts of the first conductive portions 101A, 101B exposed and able to contact other conductive portions.

The first insulating layer 103 also comprises a surrounding portion 203 which extends around the first conductive portions 101A, B of both the first coil 111A and the second coil 111B. In the example shown in Fig. 2D the surrounding portion 203 forms a closed loop around the first conductive portions 101A, 101B of both the first coil 111A and the second coil 111B. In the example of Fig. 2D the closed loop forms a rectangular shape with the first conductive portions 101A, 101B of both the first coil 111A and the second coil 111B provided within the rectangle.

Other shapes could be used for the surrounding portion 203 in other examples of the disclosure. For instance, in some examples the surrounding portion 203 does not need to form a closed loop. In some examples a conductive trace could be provided through the surrounding portion 203 so as to provide an electrical connection to the respective conductive parts of the inductive component 113. In some examples the conductive trace could be provided underneath or overlaying the surrounding portion 203.

In Fig. 2E a magnetic core 105 is formed The magnetic core 105 is formed using a two dimensional printing process such as ink jet printing, screen printing, spray coating or any other suitable process.

The magnetic core 105 may be formed from any suitable magnetic material which can be used in a two dimensional printing process. The magnetic material may be provided in the form of a paste or ink for use in the two dimensional printing process. In some examples the magnetic material could comprise magnetic rare earth metals such as neodymium alloys or any other suitable magnetic material.

The magnetic core 105 is formed so that it overlays the first insulating layer 103. The magnetic core 105 may be printed over the first insulating layer 103 so that the first magnetic core 105 is in direct contact with the first insulating layer 103. There might be no intervening components between magnetic core 105 and the first insulating layer 103 and the first conductive portions 101.

In the example shown in Fig. 2E the magnetic core 105 is provided in the same shape as the first insulating layer 103. In this example the magnetic core also surrounds the first coil 111A and the second coil 111B. In the example of Fig. 2E the magnetic core 105 completely overlays the first insulating layer 103 so that no portion of the magnetic core 105 extends over the first insulating layer 103. The first insulating layer 103 prevents any direct current path between the plurality of first conductive portions 101A, 101B and the magnetic core 105.

The magnetic core 105 may be printed so that it covers a smaller area than the first insulating layer 103. For instance the width of the magnetic core 105 may be less than the width of the first insulating layer 103. This may help to ensure that there is not accidental connection between the coils 111A, 111B and the magnetic core 105.

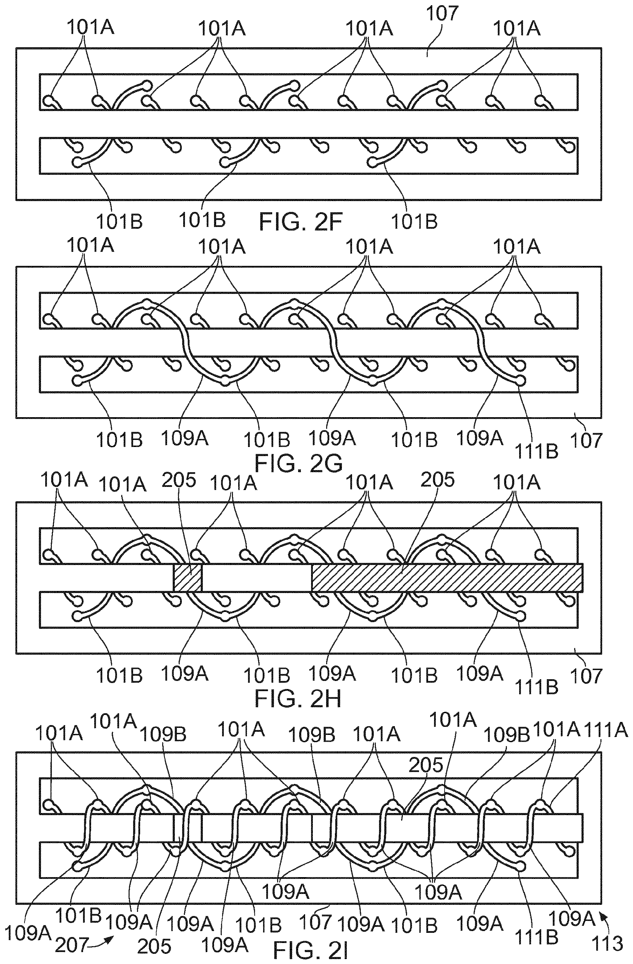

In Fig. 2F a second insulating layer 107 is formed. The second insulating layer 107 is formed using a two dimensional printing process such as ink jet printing, screen printing, spray coating or any other suitable process. The second insulating layer 107 may be formed from any suitable insulating material which can be used in a two dimensional printing process. The second insulating layer 107 may be formed from the same type of material as the first insulating layer 103 and/or the intervening insulating layer 201.

The second insulating layer 107 is formed so that it overlays the magnetic core 105. In the example shown in Fig. 2F the second insulating layer 107 has the same size and shape, or substantially the same size and shape, as the first insulating layer 103. The second insulating layer 107 is formed over both the first insulating layer 103 and the magnetic core 105 so that the first insulating layer 103 and the second insulating layer 107 form an insulating portion which surrounds the magnetic core 105.

In Fig. 2G a plurality of second conductive portions 109B of the second coil 111B are formed. The plurality of second conductive portions 109B of the second coil 111B are formed using a two dimensional printing process such as ink jet printing, screen printing, spray coating or any other suitable process.

The second conductive portions 109B of the second coil 111B may be formed from any conductive material which can be used in a two dimensional printing process. The second conductive portions 109B of the second coil 111B could be formed from the same type of material used for the other conductive portions 101A, 101B.

In the example shown in Fig. 2G three second conductive portions 109B of the second coil 111B are shown. It is to be appreciated that any number of second conductive portions 109B of the second coil 111B could be printed in implementations of the disclosure. The number of second conductive portions 109B of the second coil 111B could be the same as the number of first conductive portions 101B of the second coil 111B.

The plurality of second conductive portions 109B of the second coil 111B are formed overlaying at least part of the second insulating layer 107. The plurality of second conductive portions 109B of the second coil 111B may be printed over the second insulating layer 107 so that the second insulating layer 107 is in direct contact with the plurality of second conductive portions 109B of the second coil 111B. There might be no intervening components between the second insulating layer 107 and the plurality of second conductive portions 109B of the second coil 111B. The second insulating layer 107 may prevent any direct current paths between the magnetic core 105 and the plurality of second conductive portions 109B of the second coil 111B.

The second conductive portions 109B of the second coil 111B extend across the gaps between the adjacent first conductive portions 101B of the second coil 111B to provide a direct current path between adjacent first conductive portions 101B. This enables the first conductive portions 101B and the second conductive portions 109B to form a second conductive coil 111B around the magnetic core 105 and first insulating layer 103 and second insulating layer 107. In the example shown in Fig. 2G each of the second conductive portions 109B of the second coil 111B is printed so that a first end of the second conductive portions 109B of the second coil 111B contacts a first end of a first conductive portion 101A of the second coil 111B and a second end of the second conductive portions 109B of the second coil 111B contacts a second end of an adjacent first conductive portion 101B of the second coil 111B.

In the example shown in Fig. 2G each of the second conductive portions 109B of the second coil 111B has the same, or substantially the same shape. In the example shown in Fig. 2E the second conductive portions 109B of the second coil 111B are formed in a reverse S shape. The reverse S shape used for the second conductive portions 109B of the second coil 111B is a mirror image of the S shape used for the first conductive portions 101B of the second coil 111B. The reverse S extends diagonally from a top left point to a bottom right point. It is to be appreciated that other shapes and configurations of the second conductive portions 109B of the second coil 111B could be used in other examples of the disclosure.

In Fig. 2H a further intervening insulating layer 205 is formed. The further intervening insulating layer 205 is formed using a two dimensional printing process such as ink jet printing, screen printing, spray coating or any other suitable process.

The further intervening insulating layer 205 may be formed from any suitable insulating material which can be used in a two dimensional printing process. The further intervening insulating layer 205 may be formed from the same type of material as any of the other insulating layers 201, 103, 107.

The further intervening insulating layer 205 is formed so that it overlays at least part of the plurality of second conductive portions 109B of the second coil 111B. The further intervening insulating layer 205 may be printed over the plurality of second conductive portions 109B of the second coil 111B so that the further intervening insulating layer 205 is in direct contact with the plurality of second conductive portions 109B of the second coil 111B. There might be no intervening components between the further intervening insulating layer 205 and the second conductive portions 109B of the second coil 111B.

In the example shown in Fig. 2H the further intervening insulating layer 205 is provided as a plurality of elongated strips that extend in a horizontal direction. The elongated strips covers at least part of the plurality of second conductive portions 109B of a second coil 111B and also parts of the gaps between adjacent second conductive portions 109B of the second coil 111B. In the example shown in Fig. 2H two elongated strips are shown. The first elongated strip overlays a first subset of the second conductive portions 109B of a second coil 111B and a second elongated strip overlays a second subset of the second conductive portions 109B of a second coil 111B. A gap is provided between adjacent elongated strips. Having the gaps may reduce the amount of insulating material that is used.

In Fig. 2I a plurality of second conductive portions 109A of the first coil 111A are formed. The plurality of second conductive portions 109A of the first coil 111A are formed using a two dimensional printing process such as ink jet printing, screen printing, spray coating or any other suitable process.

The second conductive portions 109A of the first coil 111A may be formed from any conductive material which can be used in a two dimensional printing process. The second conductive portions 109A of the first coil 111A could be formed from the same type of material used for the other conductive portions 101A, 101B, 109B.

In the example shown in Fig. 2I ten second conductive portions 109A of the first coil 111A are shown. It is to be appreciated that any number of second conductive portions 109A of the first coil 111A could be printed in implementations of the disclosure. The some examples the number of second conductive portions 109A of the first coil 111A could be the same as the number of first conductive portions 101A of the first coil 111A.

The plurality of second conductive portions 109A of the first coil 111A are formed overlaying at least part of the further intervening insulating layer 205. The plurality of second conductive portions 109A of the first coil 111A may be printed over the further intervening insulating layer 205 so that the further intervening insulating layer 205 is in direct contact with the plurality of second conductive portions 109A of the first coil 111A. The further intervening insulating layer 205 may prevent any direct current paths between the second coil 111B and the first coil 111A.

The second conductive portions 109A of the first coil 111A extend across the gaps between the adjacent first conductive portions 101A of the first coil 111A to provide a direct current path between adjacent first conductive portions 101A. This enables the first conductive portions 101A and the second conductive portions 109A to form a first conductive coil 111A around the magnetic core 105 and first insulating layer 103 and second insulating layer 107. In the example shown in Fig. 2I each of the second conductive portions 109A of the first coil 111A is printed so that a first end of the second conductive portions 109A of the first coil 111A contacts a first end of a first conductive portion 101A of the first coil 111A and a second end of the second conductive portions 109A of the first coil 111A contacts a second end of an adjacent first conductive portion 101A of the first coil 111A.

In the example shown in Fig. 2I each of the second conductive portions 109A of the first coil 111A has the same, or substantially the same shape. In the example shown in Fig. 2E the second conductive portions 109A of the first coil 111A are formed in an S shape. The S shape used for the second conductive portions 109A of the first coil 111A is a mirror image of the reverse S shape used for the first conductive portions 101A of the first coil 111A. The S extends diagonally from a bottom left point to a top right point. It is to be appreciated that other shapes and configurations of the second conductive portions 109A of the first coil 111A could be used in other examples of the disclosure.

The method shown in Figs. 2A to 2I enables an inductive component 113 to be formed. In the example of Fig. 2I the inductive component 113 is a transformer 207. In the example shown in Fig. 2I the transformer 207 is a shell type transformer in which the magnetic core 105 is configured to encircle the coils 111A, 111B.

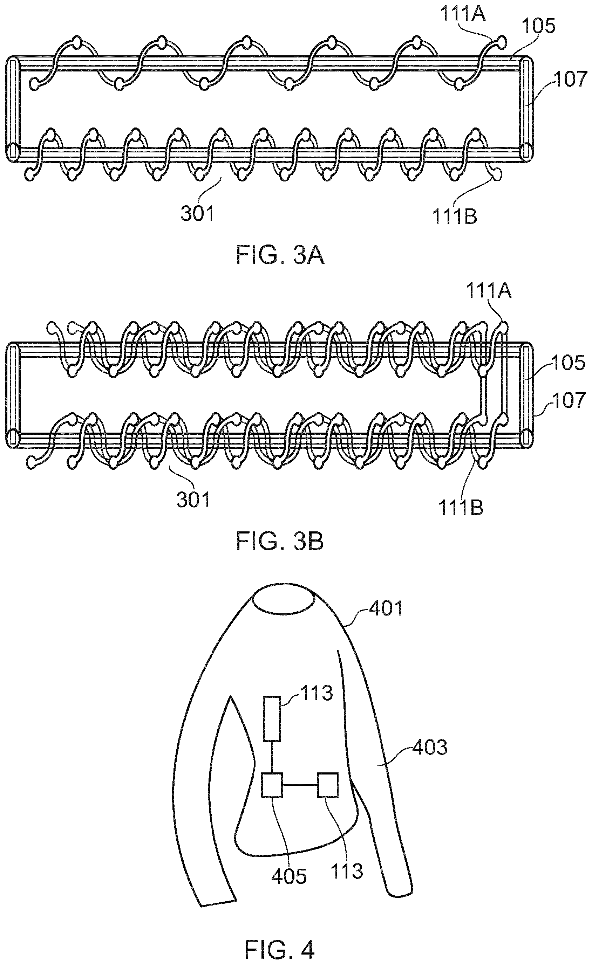

Figs. 3A and 3B show core type transformers 301 in which the coils 111A, 111b encircle the magnetic core 105. The transformers 301 shown in Figs. 3A and 3B could be formed using a similar method to that shown in Figs. 2A to 2I.

In the example shown in Fig. 3A the magnetic core 105 is provided in a rectangular shape. The insulating layers 103, 107 which surround the magnetic core 105 are also provided in a rectangular shape.

A first coil 111A is provided on a first side of the magnetic core 105 and a second coil 111B is provided on a second side of the magnetic core 105. The second coil 111B may be provided on an opposite side of the magnetic core 105 to the first coil 111A. The second coil 111 has more turns than the first coil 111A so as to provide a step up transformer.

The example core type transformers 301 shown in Fig. 3A could be formed using a similar method to the method shown in Figs. 1A to 1E. As the different coils 111A, 111B are provided along different sides of the magnetic core 105 there is no need for any intervening insulating layers. In these cases the respective conductive portions of the coils 111A, 111B could just be printed at the required locations.

In the example shown in Fig. 3B the magnetic core 105 is also provided in a rectangular shape. The insulating layers 103, 107 which surround the magnetic core 105 are also provided in a rectangular shape.

In the example of Fig. 3B both the first coil 111A and the second coil are provided along two sides of the magnetic core 105. The example core type transformers 301 shown in Fig. 3B could be formed using a similar method to the method shown in Figs. 2A to 2I. As the different coils 111A, 111B are provided along the same sides of the magnetic core 105 the intervening insulating layers may be provided between the respective conductive portions of the coils 111A, 111B.

The transformers 207, 301 shown in Figs. 2I, 3A and 3B can be used wherever step up or step down voltage is required within an electronic device. For instance the transformers 207, 301 could be used to provide an increased voltage for use with a vibratory output device or with any other suitable components.

In some examples the inductive components 113 shown in Figs. 1E, 2I, 3A and 3B may be formed on fabric. The fabric could be used as part of a wearable electronic device. In other examples the inductive components 113 could be formed on a flexible substrate and transferred to the fabric after the inductive components 113 have been formed. The use of the flexible substrate could be useful where the inductive components 113 are to be used on a fabric which might not be suitable for use as a substrate for a two dimensional printing process. For example a fabric with a high elasticity content might not be suitable for such processes.

It is to be appreciated that in some examples the respective parts of the inductive components 113 could be formed using the same two dimensional printing process. In other examples different two dimensional printing processes could be used for forming different respective parts. For instance the conductive portions 101, 109 could be formed using inkjet printing while the insulating layers 103, 107 could be formed using a screen printing process. The type of two dimensional printing process that is used for each of the respective parts of the inductive components 113 may be selected based on the material that is used for the parts.

Fig. 4 shows a wearable electronic device 401 comprising at least one inductive component 113 where the inductive component could have been formed using any of the methods described above.

In the example of Fig. 4 the wearable electronic device 401 comprises a garment 403 comprising one or more inductive components 113. The garment 403 comprises an item of clothing which is arranged to be worn by a subject. In the example of Fig. 4 the garment 403 comprises a shirt. Other items of clothing could be used in other examples of the disclosure. For instance the item of clothing could comprise a strap which could be attached to any suitable part of a subject's body, or any other suitable article of clothing.

In the example of Fig. 4 the inductive components 113 are coupled to other circuitry components 405. The other circuitry components could be antennas, output devices or any other components which need to be coupled to an inductive component 113.

Examples of the disclosure therefore provide inductive components 113 that are formed using two dimensional printing processes. This provides a flexible method of manufacture that can be used for different types of inductive component 113. This also provides inductive components that are suitable for use in wearable electronic devices. It is to be appreciated that the inductive components 113 could also be used in other types of devices, for instance the inductive components 113 could be used in any devices where it may be useful to have a small inductive component 113.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to 'comprising only one...' or by using 'consisting'.

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although embodiments have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain embodiments, those features may also be present in other embodiments whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer and exclusive meaning.

The presence of a feature (or combination of features) in a claim is a reference to that feature) or combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. An inductive component comprising:
a plurality of first conductive portions;
a first insulating layer, wherein the first insulating layer overlays at least part of the a plurality of first conductive portions;
a magnetic core at least partially overlaying the first insulating layer;
a second insulating layer, wherein the second insulating layer overlays the magnetic core; and
a plurality of second conductive portions overlaying at least part of the second insulating layer so that the plurality of second conductive portions contacts the plurality of first conductive portions to form a conductive coil around the magnetic core and first insulating layer and second insulating layer;
wherein the plurality of first conductive portions, the first insulating layer, the magnetic core, the second insulating layer and the plurality of second conductive portions are formed using one or more two dimensional printing processes.

2. An inductive component as claimed in any preceding claim wherein respective parts of the inductive component are formed using different two dimensional printing processes and the respective parts comprise one or more of the plurality of first conductive portions, the first insulating layer, the magnetic core and the plurality of second conductive portions.

3. An inductive component as claimed in any preceding claim wherein the two dimensional printing processes comprise one or more of; ink jet printing, screen printing, spray coating.

4. An inductive component as claimed in any preceding claim wherein the inductive component is formed on fabric.

5. An inductive component as claimed in any of claims 1 to 4 wherein the inductive component is formed on a flexible substrate and transferred to fabric after the inductive component has been formed.

6. An inductive component as claimed in any preceding claim comprising:
a first conductive coil around the magnetic core and first insulating layer and second insulating layer; and
a second conductive coil around the magnetic core and first insulating layer and second insulating layer;
wherein the first coil and the second coil are configured to form a transformer.

7. An inductive component as claimed in claim 6 wherein an intervening insulating layer is provided between portions of the first conductive coil and portions of the second conductive coil.

8. An inductive component as claimed in any of claims 6 to 7 wherein the transformer comprises at least one of; shell type transformer, core type transformer.

9. A wearable electronic device comprising an inductive component as claimed in any preceding claim.

10. A method of forming an inductive component comprising:
forming a plurality of first conductive portions;
forming a first insulating layer, wherein the first insulating layer overlays at least part of the plurality of first conductive portions;
forming a magnetic core at least partially overlaying the first insulating layer;
forming a second insulating layer, wherein the second insulating layer overlays the magnetic core; and
forming a plurality of second conductive portions overlaying at least part of the second insulating layer so that the plurality of second conductive portions contacts the plurality of first conductive portions to form a conductive coil around the magnetic core and first insulating layer and second insulating layer;
wherein the plurality of first conductive portions, the first insulating layer, the magnetic core, the second insulating layer and the plurality of second conductive portions are formed using one or more two dimensional printing processes.

11. A method as claimed in claim 10 wherein respective parts of the inductive component are formed using different two dimensional printing processes and the respective parts comprise one or more of the plurality of first conductive portions, the first insulating layer, the magnetic core and the plurality of second conductive portions.

12. A method as claimed in any of claims 10 to 11 wherein the two dimensional printing processes comprise one or more of; ink jet printing, screen printing, spray coating.

13. A method as claimed in any of claims 10 to 12 wherein the inductive component is formed on fabric.

14. A method as claimed in any of claims 10 to 12 wherein the inductive component is formed on a flexible substrate and transferred to fabric after the inductive component has been formed.

15. A method as claimed in any of claims 10 to 14 comprising forming a first conductive coil around the magnetic core and first insulating layer and second insulating layer: and
forming a second conductive coil around the magnetic core and first insulating layer and second insulating layer;
wherein the first coil and the second coil are configured to form a transformer.
